Europäisches Patentamt

European Patent Office

Office européen des brevets

(19)

(11) Publication number: 0 104 003
A2

# EUROPEAN PATENT APPLICATION

(21) Application number: 83304897.8

(22) Date of filing: 24.08.83

(51) Int. Cl.³: **G 02 F 1/133**
**G 09 G 3/36**

(30) Priority: 26.08.82 US 411823
17.08.83 US 523399

(43) Date of publication of application:
28.03.84 Bulletin 84/13

(84) Designated Contracting States:
AT BE CH DE FR GB IT LI LU NL SE

(71) Applicant: CRYSTALVISION INCORPORATED
1313 Geneva Avenue
Sunnyvale California 94089(US)

(72) Inventor: Young, Robert A.
4811 Tonino Drive
San Jose California 95136(US)

(72) Inventor: Zuckerman, Matthew M.
167 Bryant Street
Palo Alto California 94310(US)

(74) Representative: Dixon, Donald Cossar et al,
Gee & Co. Chancery House Chancery Lane
London WC2A 1QU(GB)

(54) Liquid crystal display.

(57) A liquid crystal display (20) includes liquid crystal material contained within a defined cavity (34), and the optical characteristics are changed in response to electrical excitation signals to produce an information display and to erase the display. The display includes a pair of substrates (30,32) between which the liquid crystal material, which may include dipolar particles, is situated. The substrates are spaced by spacing particles applied to at least one of the substrates, and connected to driving electronics by bonding the electrical circuit leads (38,40,42) to flexible electric circuit elements.

FIG.3

EP 0 104 003 A2

## LIQUID CRYSTAL DISPLAY

Liquid crystal (LC) materials were first used to produce liquid crystal displays in the early 1960's. Liquid crystal displays provide highly reliable, low voltage, low power readouts. The first commercial displays utilized dynamic scattering wherein glass was treated to cause the materials to align in an ordered way and a charged particle was passed through the material when disordering or change from clear (non-scattering) to milky (scattering) was required.

The high volume production of liquid crystal displays for calculators and watches started in the mid 1970's utilizing the twisted nematic or field effect method. The front and back planes of a glass envelope were treated with various well known materials and processes such that the liquid crystal material would cause a 90° rotation of the plane of linearly polarized light passing through the cell in the unenergized state. When a field is applied to the material across the front and back plane, the material changes into an ordered state which provides no optical rotation. By the use of a combination of polarizer and analyzer, it is possible to have these changes in ordering of the material appear as changes between absorbing or transmissive states. The drawback of these materials is that each area has to be individually addressed which makes it difficult to have a high density of information points. A further problem is that these materials are in a non-stable state and must be electronically refreshed. A further problem is that polarizers and analyzers and back reflecting materials are all added to the outside of the package. This creates manufacturing complexities, decreases the optical performance of the product and limits its resistance to harsh environments.

In an attempt to overcome some of these problems nonnematic materials which exhibit cholesteric and smectic liquid crystal properties have been explored, but have not yet reached commercialization. Associated with the cholesteric and smectic liquid crystals are phenomena which include hysteretic memory effects and electrically controllable persistance. The prior art utilizes homeotropic boundary conditions, the arrangement of the liquid crystal material within a liquid crystal display cavity.

In an attempt to eliminate the polarizers, dye materials inside and along with the LC materials have been used. Unfortunately, these LC materials, usually highly linear molecular dyes soluble in aromatic solvents (anthraquinone and azo dyes being representative), are ultraviolet (UV) sensitive and must be used as mixtures to obtain black, the most desirable color. They tend to fade and discolor because some of the materials are destroyed more quickly than others. Dye degradation by UV is much faster than cell-operation related failure modes. Thus, the display degrades at essentially the same rate with UV exposure, whether or not it is in operation.

1.  All dyes are inherently unstable, particularly with respect to UV light. Dyes with the most compatible structure for LC interaction are usually most susceptible to degradation.

2.  Dyes, on an equal particle basis, do not have the absorbing efficiency of pigment materials. As they cannot afford to be added to the LC material to more than about 5% without interfering with the LC material's response to electric fields or exceeding solubility limits of the liquid crystal host, the "absorbing" state of the LCD is still quite highly transmissive.

3.  The combined problems of stability (#1 above), solubility, and inertness to reacting with the LC material force the selection of dyes with far less than ideal linear configurations. The selected dyes, due to structural differences, do not couple as strongly with the LC material and thus do not replicate the LC

- 4 -

alignment as closely as desired. The effect of this is that the "absorbing" state is slightly more transmissive than predicted by #2 above and, more important, the "non-absorbing" or addressed state still shows substantial residual absorption. The overall result is that the contrast ratio derived from the relative transmission ratio of absorbing and non-absorbing states is reduced.

4. Guest-Host LCD's based on conventional LCD construction offer only light images (addressed) against a darker (non-addressed) background. This is a visually undesirable mode for passive displays.

5. There is no "black" dye - the most visually desirable display (black on white). At best, dark gray/light displays are produced which, with aging (#1 above), will shift away from gray toward the color of the most stable dye of the three or more dyes in the mixture used to approximate neutral gray.

6. The synthesis of dyes leads to high degrees of ionic and other contaminants in the resulting dye. For normal dye uses, these are of no consequence. Purification of dyes to reduce LC display current (power and lifetime considerations) and improve chemical compatibility with the LC material is very difficult.

It is well known that highly electromagnetic radiation absorbing structures can be made by fabricating electrically conductive dipole "antennas" whose major dimension is related to the intended wavelength to be absorbed. Classical electromagnetic analysis of dipole antennas defines this relationship in detail. The other dimensions of the dipole antenna should be small compared to the major dimension. Minute flakes, rods, needles, etc.,of even quite electrically resistive materials have far higher absorbing efficiency than dye molecules. Suspensions of such materials in both solid and liquid media are well known in the art: "colloidal gold", colored glass, light control coatings or tinting of photographic and eyeglass lenses are examples. Attempts have been made to utilize such materials to create switchable display devices by suspending these particles in a non-interactive fluid medium and switching them from a random orientation (absorbing) state to an aligned (non-absorbing) state by application of electric fields.

The following are significant limitations of these devices which are known to exist:

1. Only dark background/light image displays can be created.

2. Suspension stability is a problem (settling, agglomeration, adherence to substrates, chemical stability all have limited lifetimes).

3. Because of weak interaction between the particles and electric fields, higher working voltages are required than for typical LCD's.

There are advantages of these displays, among which are:

1. True black as well as colors are readily producible.

2. Absorbing efficiency in random orientations is high and, with maximal geometric aspect ratio, aligned state absorption is low creating high contract ratios.

3. Particle size and geometry are determined by both chemical structure and the means by which the particle was physically fabricated.

4. Particles are highly stable with essentially no UV degradation.

5. Particles, unlike molecular dyes, can be coated, anodized, encapsulated, or otherwise surface modified to improve or enhance compatibility with the surrounding medium.

Many other types of liquid crystal displays also exist at a laboratory or limited production level and some may reasonably become more widely produced in the future. Representative but not restrictive examples are:

1.    Guest-Host (dichroic dye in LC host).

2.    Smectic or cholesteric LC mixture, including both electrical and thermally addressed types.

3.    Any of the previously cited LC cells with internal electrical circuits (varistor films, thin film transistors, etc.) at each display point, constituting an array which assists the optical switching of the LC in response to electrical addressing.

A common characteristic for all such LCD's is the need for maintaining a highly uniform cavity thickness between the LCD substrates. This cavity contains the LC material which creates the selectively addressable image elements.

Economics in manufacture dictate the use of two plates of glass as the primary material for forming the cavity to hold the LC materials, although plastic, metallic and ceramic materials have been utilized to a lesser extent. The requirement of the product generally requires a cavity of uniform cross-section in the range of 0.3 to 0.7 thousandths of an inch with a $\pm$ 10% tolerance. The only specification on commercial grade glass is $\pm$ 0.004 inch with no specification on bow or camber. This does not create much of a problem on small displays up to 2 inches in a major dimension, wherein the spacing is usually created by a material contained in the seal area. However, on larger displays, the maintenance of uniform cavity is of major concern. The cavity thickness is also important since it affects field density and desired change in material and speed of change of material.

Attempts at overcoming the problem of uniform cavity cross-section included the use of rigid particles or quartz glass threads sprinkled over the area of one surface before the second plate is attached and sealed. The problem with these solutions are the random nature of the application and incidence of overlap with fibers which results in uneven cavity cross-section. Cost as well as technical limits require that LCD's use glass substrates of "commercial" flatness. This type glass has not heretofore been adequate for large area displays. The plate to plate substrate spacing in LCD's to achieve uniform electro-optical performance has been obtained by either:

    1. selective etching of relieved area (depressed) in the substrate;

2.   placing spacer materials between the substrates in the viewing area (leads or fibers); or

3.   putting spacer material in the peripheral seal materials.

The first is neither cost effective nor readily controllable for large area mass production LCD's. In the second, the spacers-in-viewing area technique is difficult to optimize to produce uniform spacer densities over large areas. In the third, spacer materials in the seal are effective only for small area displays as this cannot control glass bowing except near the seal edges.

An area of extreme difficult in LCD's is the method of electrical attachment of the display. Initially, pins were attached to the glass. The transparent electrically conductive coatings on the LCD glass substrates are neither solderable or bondable, making contact with the LCD by conventional means difficult. The surface affinity of these conductive materials for oily contaminants and the low abrasion resistance of these films limits the use of "wiping" action spring contacts. Sufficient wiping pressure to remove the contaminants quickly, also cuts through the conductive coating. Originally, metal pins were crimped to the glass and reinforced with encapsulant layers, of epoxy or similar material. This method has both contact reliability problems and is limited to low-density pinouts due to the physical size requirements for adequate mechanical strength of the pin. Bondable or solderable pads can be deposited over the thin film oxide but are not cost effective and frequently suffer adhesion problems.

Most recently, stacks of alternating conductive and dielectric sheets of silicone rubber have been cut into strips which provide high density interconnection paths when compressed between the LCD and printed circuit board. Neither the carbon or metallic base conductive layers offer adequately low contact or bulk resistance for many display applications. The use of elastomeric conductor strips reduces the alignment problem, but requires careful packaging design to assure pressure contact. A further problem with the conductive elastomeric strip is a change in material composition at the contact interface that occurs with continued electrical pulsing of the strip. This results in a change in contact resistance over time.

Among the other methods unsuccessfully utilized in the prior art for making high density interconnection between the display glass substrate and the supporting electronics are the following:

1.    Soldering or reflow soldering to ribbon cable which requires expensive solderable metallization of the glass and may cause thermal damage. This approach is expensive, yields poorly, and cannot be readily adapted to high volume, low cost production.

2. Elastomeric strips (conductive silicone rubber stack). These strips are not readily available in long lengths, have high contact and bulk resistivity which limit their current handling capabilities and are relatively expensive. The necessary mechanical containment of the display, printed circuit board and connector, complicate assembly. Further, the need for uniform compression of the connector in large displays has been a difficult design problem.

3. Flexible circuits, reflow soldered. These require expensive solderable metallization of the glass and can cause thermal damage to the liquid crystal material during soldering.

4. Use of flexible circuits with compression contact (e.g., held in proper orientation by a compressed rubber bar). This method suffers from poor contact reliability and it is difficult to assemble.

It is an object of the invention to overcome the limitations of the prior LC displays and to produce an LC display with a high density of addressable points.

It is a further object of the invention to produce a large area LCD.

It is a still further object of the present invention to produce an LCD without one pin to one point addressing and using one pin to many points with any combination of two pins uniquely addressing one and only one point.

It is further an object of the present invention to provide an LCD with uniform cavity thickness.

It is still further an object of the present invention to provide electrical connections for an LCD wherein the contact resistance is low, substantially constant over the useful life of the product and the alignment pressure between the display and the package are not critical.

It is an object of the present invention to produce an LCD which operates without external polarizers and internal dyes.

It is a still further objective of the present invention to produce an LCD using glass with "commercial" flatness wherein an internal cavity is formed by incorporation of the spacing material into the viewing area by one of several methods, any of which overcome the previously cited problems of spacer uniformity, clumping and overlap (stacking).

It is a still further objective of the present invention to produce a LCD with homogeneous boundary conditions in the cavities of the liquid crystal display using cholesteric and smectic materials.

It is a still further objective of the present invention to produce an LCD wherein once written upon the display will remain such that no intelligent electrical refreshing will be required.

In accordance with the invention, an LCD display is provided in which a liquid crystal material is contained within a defined cavity. Electrical excitation signals are applied to the liquid crystal material to affect at preselected locations of the display, changes in the optical characteristics of display which remain in said selected locations after removal of the electrical excitation signals without the necessity for periodically refreshing the optical characteristics of the display.

More specifically, the liquid crystal material contained within the defined cavity is in either the cholesteric or smectic phase and has a planar structure in the absence of the predetermined electric excitation signals.

The electrical excitation signals include first electrical excitation signals which are applied in sequence to portions of the display such that at the end of the sequence all portions of the display have received the first electrical excitation signal and second electrical excitation signals which are applied to selected areas of each of the portions of the display as the portion is receiving the first electrical excitation signal to cause a change in the optical characteristics of the selected areas. To remove the changes in the optical characteristics of the display caused by the

- 14 -

first and second electrical excitation signals, third or erase electrical signals are applied to the display to change the optical characteristics of the display to selectively remove information from the display.

As a further aspect of the invention, flexible electrical circuit elements are bonded to a glass substrate to interconnect with patterns of conductive material formed on the glass substrate for an LC display by: (1) printing conductive resin material on flexible circuit leads in registration with the pattern of conductive material; (2) drying the conductive resin; (3) aligning the pattern of conductors to be interconnected with the flexible circuit leads; and (4) fusing the flexible circuit leads onto the glass substrate by melting and compressing the resin to thereby interconnect with the patterns of conductive material.

As a still further aspect of the invention, a flexible electric circuit is created by cutting a pattern in a flat plate or roll, filling said pattern with a conductive resin and applying said plate or roll to a flexible substrate such that said conductive material is transferred to said substrate forming a conductive pattern thereon.

These and other features of the invention will be understood by those skilled in the art, particularly when taken in conjunction with the following description and drawings, of which:

Fig. 1 is a front elevation view of a communication terminal including a flat panel liquid crystal display constructed in accordance with the invention;

Fig. 2 is a side elevation view of the communication terminal including a flat panel liquid crystal display contructed in accordance with the invention;

Fig. 3 is a diagrammatic representation of a flat panel liquid crystal display for the purpose of illustrating the construction thereof;

Fig. 4 is a block diagram of the electronics required to operate the communication terminal illustrated in Figs. 1 and 2;

Fig. 5A is a signal diagram showing the electronic signals applied during a particular time interval to electrical conductors to illustrate how the elements of the flat panel liquid crystal display are activated;

Fig. 5B illustrates a five-by-five matrix pattern which, taken with Fig. 5A, illustrates how the elements of the liquid crystal display are activated; and,

Figs. 6 and 7 show respectively the response time of a display constructed in accordance with prior art liquid crystal display techniques and the liquid crystal display constructed according to the invention, which illustrates the significantly decreased response time of the liquid crystal display of the invention.

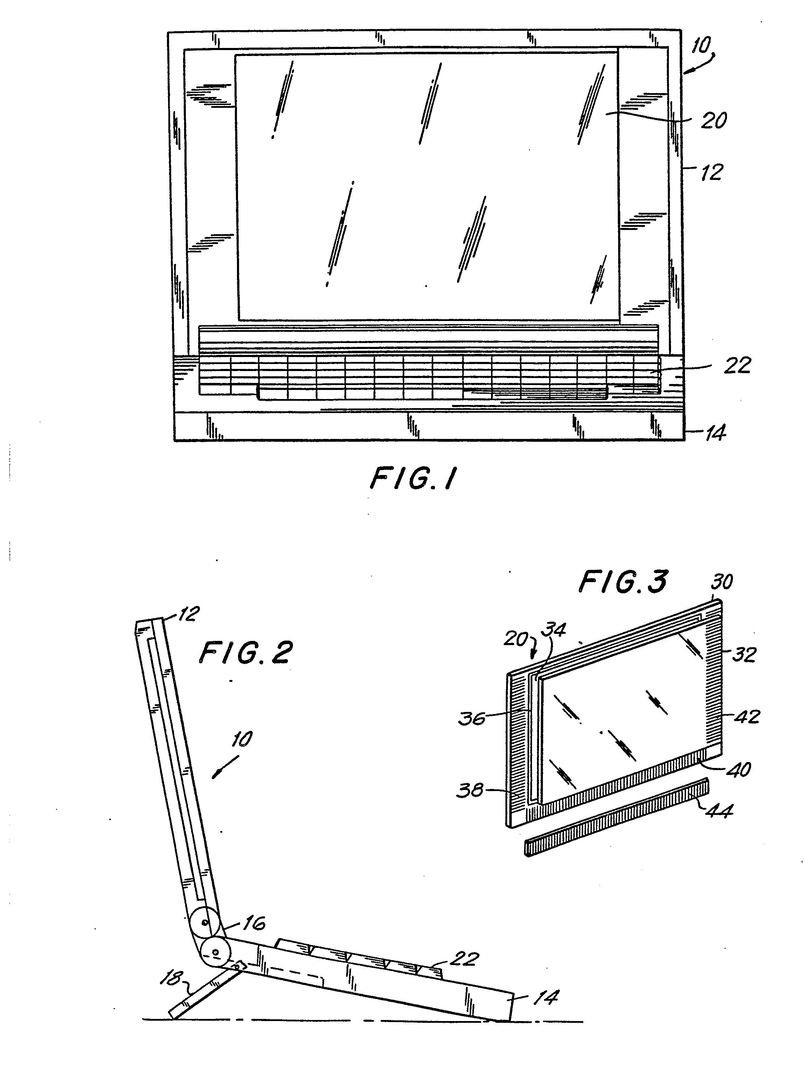

Figs. 1 and 2 illustrate a communication terminal which is an important application for the liquid crystal display of this invention. The use of the liquid crystal display in the communications terminal will produce a large flat screen display having a relatively large viewing area and excellent contrast and viewing capabilities. Of course, as will be understood by those skilled in the art, there are many other applications for the liquid crystal display described herein.

Referring to Figs. 1 and 2, the communications terminal 10 includes a cover 12 mounted on a base 14 via an adjustable hinge 16 so that the cover 12 can be rotated about hinge 16 to close the communications terminal into a flat package or to open the communications terminal and position cover 16 at any desired angle for viewing. A support 18 is hingedly mounted in the bottom of base 14 so that it can be rotated out of the bottom of base 14 to support the communications terminal on a work surface, as shown in Fig. 2, or secured within the profile of the bottom of base 14 when the communications terminal is stored or transported.

A flat panel liquid crystal display 20 constructed in accordance with the invention is mounted in the cover 12. A typical liquid crystal display for a communications terminal has an undifferentiated matrix of 560 columns by 250 rows (140,000 pixels) and a viewing area of 9.18 inches by 5.40 inches (approximately 11-inch diagonal). It is glare-free, can be read in ambient or auxiliary light and has been found to be readable in full sunlight.

Mounted in the base 14 is a keyboard 22 having a plurality of data input keys which may be of any standard or conventional design. Also mounted within base 14 (not shown) are the electronic components (described below) for causing information to be displayed on liquid crystal display 20. The overall dimensions of the typical communications terminal illustrated in Figs. 1 and 2 are 10 inches by 13 inches by 3 inches which is approximately the size of a 3-ring binder. Total weight is less than five pounds.

A typical mixture of the liquid crystal materials used in the liquid crystal display 20 is obtained by adding 10% by weight of cholesterol nonanoate to BDH E-7 LC mixture (biphenyls). Solution is accomplished by heating the E-7 to the isotropic point (approximately 60°C) and stirring to effect solution of cholesterol nonanoate solids. Other suitable liquid crystal materials include mixtures of positive dielectric anisotropy nematic mixtures with cholesteric, smectic and chiral nematic additives.

The display in accordance with the invention permits addressing of even high order matrices. This technology eliminates the problem of partial-activation of unselected pixels, which has made this format unusable with conventional TNFE displays. An entire row or column of pixels is "selected" for writing. This line is then "written" in parallel (all points on the line simultaneously) rather than the sequential scan of conven-tional displays. Therefore, matrix addressing is accomplished for an 80-column by 25-row display with approximately 1/250 the number of contacts which would be required for direct, point-by-point addressing. A further development is the inclusion of a non-dye guest material in the display which allows operation without polarizers, without the lifetime/reliability problems encountered with molecular dyes.

The large area flat display constitutes a package with a surface area of greater than 40 square inches and an internal cell thickness of a half thou-sandth of an inch ($\pm$ 10%) containing several milligrams of liquid crystal material. The finished glass package is 0.125 inch thick.

Dipolar particles may be incorporated into a LC medium and utilized in LCD's to overcome limitations in the present displays. These particles may, as required, be surface modified to enhance their interaction with the LC material, improve chemical inertness, modify absorption characteristics, and control dispersion stability.

Dipolar displays made in accordance with the invention differ from the prior dipolar particle displays in at least the following respects:

1.   Operation of the display is independent of any interaction between the dipolar particles and the addressing field. All field interaction is by the LC medium.

2. There is an absence of agglomeration or sedimentation of dipolar particles.

3. A dark image (black) on white (clear) background can be produced.

4. LCD level power/voltage is lower due to the high sensitivity of the liquid crystal materials to electric fields and their high resistivity.

Such displays differ from conventional LCD's in at least the following:

1. No UV degradation.

2. True "black" with single species of particle.

3. High contrast ratio.

4. High absorbing efficiency - "black" not "gray".

5. Chemical inertness to LC material is readily achievable to provide long lifetime.

6. Dark image on light field is possible.

7. Particles may be obtained in high purity more easily than dyes.

Dipolar particles, with the exception of herapathite and iodoquininesulfate (due to migration or chemical reactivity of iodine) may be utilized. Rodlike or needlelike particles are more desirable than flake forms. In addition, manufacturing techniques for solid conductive needles (e.g., sublimation and crystallization) are applicable as is cladding of non-conducting materials by, for example, plating, chemical solution deposition, reduction or vacuum metallization. Well know antenna theory conclusions apply for calculation of required dimensions.

For power/voltage considerations, it is desirable to operate below the range of cell thicknesses for dipole (non-LCD) displays. Dipole/LCD cells should be from 6 micron to 25 micron thickness, although where slower response times are required, cells may be built to the limit of .05 millimeter (approximately .002"). Particles must be freed of all suspending solvents in preparing the LC mixture. If high purity solvents are used, particularly low boiling materials such as ether or, preferable, freon, the suspension may be directly mixed with the LC materials followed by solvent removal by evaporation. Hygroscopic solvents (alcohols, benzene) should be avoided. Particles such as aluminum and gold may be directly incorporated into LC mixtures without compatibility problems. Silver, chromium and copper should be avoided unless surface clad.

Surface modification, in accordance with this invention, offers substantial advantages. Anodized aluminum can be used to create a variety of color effects even without the use of dyes. Oxide thickness alone produces "warm" tones of yellows and browns. The oxide formed by exposure of particles to aqueous dilute NaOH is adequate to reduce finished cell conductivity. Other coatings known to be compatible with LC material include: polyvinyl alcohol from aqueous solution; $SiO_2$ from $SiH_4$ decomposition or reactive evaporation of SiO; SiO by thermal evaporation of SiO; surface polymerization of para-zylene (Parylene-Union Carbide). These coatings all provide electrical and chemical isolation of the dipolar particle without significant change in particle geometry.

Surfaces may be treated to enhance the interaction between the particle and LC medium. A typical example is treatment of a polar surface particle by exposure to a dilute solution of N-methyl-p-aminopropyl trimethoxysilane. This silane forms a mono-layer on the surface which enhances greatly the parallel alignment between a needle and surrounding LC molecules. This compound requires a polar surface such as that formed on aluminum by anodizing or NaOH solution treatment.

The silane concentration is not critical as the polar surface will extract silane from solution until it is completely occluded (0.25-0.5% is typical). It is advantageous to prepare the particles without sizing. Particles may then be surface conditioned by the above techniques and subsequently graded for size by conventional practices. Typically, the resulting particles are incorporated by mixing directly with the LC material in the amount of 0.25-5%, by weight. The resulting mixture may be incorporated into the LCD by standard practices. If the particles are incorporated into a homeotropic - surface cell with a negative dielectric anisotrophicLC mixture (either nematic or smectic), an absorbing image will occur when addressed by conventional means. If a positive LC mixture is used in a homogeneous surface cell (without or without twist), a non-absorbing area will be greated by addressing.

In accordance with the invention, flexible circuits are bonded to the glass substrate using thermally activatable (either thermoplastic or thermosetting) organic resins with conductive particles built-in. Among the advantages of this new bonding method are:

1.    Metallization of the glass is not required.

2.    High temperature soldering operations are not required.

3.    There is low contact resistance.

4.    Noble metals are not required.

5.    The method is economical since the conductive material is applied only where it is needed, to create both the connection and the flexible circuit itself.

6.    High cost or technically sophisticated assembly equipment is not required.

7.    There are no waste or emission  control problems.

With reference to Fig. 3, the procedure for bonding flexible circuits to the glass substrate to create the liquid crystal display will be described. As shown, the display 20 includes a rear plate 30 and a front plate 32, with a cavity 34 therebetween. A seal 36 is applied on all four edges to seal the rear plate 30 and front plate 32 with the cavity 34 therebetween. A matrix of intersecting points is formed between the parallel lines in rear plate 30 and the perpendicular parallel lines in front plate 32 using conventional techniques, terminating in connection pads 38, 40 and 42 along the outer edges of rear plate 32. Interconnection of the liquid crystal display to external circuitry is accomplished through the following procedure. First, conductive material is screen printed on the connection pads 38, 40, 42 and/or the glass substrate in registration with the patterns to be interconnected. The material is then dried to a hard, handleable state. Optionally, dielectric material can be printed around the conductor pads 38, 40, for additional strength in final assembly and to assure control of conductive material flow during the seal. If this optional step is carried out, the dielectric is hardened to a handleable state before alignment and final sealing to the LCD. The patterns to be interconnected are then aligned. Using a heater bar 44 (bag-sealer) the flexible circuit is fused onto the glass by melting and/or cross-linking the resin material. The assembly is then cooled and the interconnection has been made.

Representative but not restrictive compositions for the resins are as follows:

Dielectric:

1. Polyvinyl butyl (thermo plastic); or weight of Miller Stevenson Adjicure B-002 (thermosetting).

Vehicle: Cyclohexanone and butyl carbitol to produce printable rheology.

Flow control: normal five percent fused silica to reduce stringing; or

3. Englehart A-3840 (thermosetting).

Conductive: to any of the dielectric material compositions above, add nickel powder such as Cobaloy X-3124 to about 75 percent by weight of the final mixture.

Compositions such as the thermosetting resin formulations in the previous examples in either or both the dielectric and conductive mixtures, may be directly printed upon a suitable substrate to create the flexible circuit itself. Typical substrate materials include polyester and polyamide films of varying thicknesses. This method for creating the flexible circuit offers an economical, reliable alternative to conventional flexible circuits. For further economy, carbon may be substituted for metallic conductive particles in this embodiment.

Screen printing of circuits on flexible films has been widely practiced for such signal-level applications as keyboards and switches. For some display applications, the limited conductivity and high contact resistance of this present art are acceptable. Many applications, both in display interconnection and circuit board to circuit board interconnection cannot accept these limitations.

Screen printing cannot deposit the necessary thickness of conductive material required to produce high conductivity circuits. As conductivity, for a given conductive mixture is determined by the cross-sectional area of the printed circuit, high conductivity implies large area which requires either thick printing or wide printing or both. The dimensional limits for display interconnects and state-of-the-art PCB's prohibit wide printing. Screen printing technology cannot compensate for this with proportionately thicker depositions.

Such thick depositions, approximately one order of magnitude greater than achieved by screen printing, can be achieved in this invention by utilizing a selectively relieved flat plate or circular roll. The conductive pattern to be printed is cut to the required depth below the surface of the plate or roll. This incised pattern is then filled with the conductive mixture by wiping blade or analogous method. The surface of the plate or roll is wiped clean of conductive mixture by a doctor blade, squeegee or analogous method. The filled roll or plate is pressed against the substrate to be printed and pulled away. Adhesion of the conductive mixture to the substrate substantially removes the conductive mixture from the incised areas of the roll or plate and transfers it to the substrate.

Subsequently, the roll or plate may be reloaded, wiped, and used to print again. Printed substrates are given an appropriate solvent removal/curing cycle and may then be utilized for interconnection as the cited "flexible circuits".

The display in accordance with the invention has the following advantages:

1.  Commercially available glass is satisfactory, thus allowing use of available indium/tin oxide conductive coatings rather than requiring a custom coating.

2.  Ordinary 0.060 inch thick glass can be used eliminating the need for more expensive glass, either thicker or of the lapped varieties.

3.  Alignment of front and back glass to ± 0.002 inch assures the fineness and accuracy of the pixels.

4. 0.006 inch width pixel with 0.001 inch wide spacing is easily achieved in production. 0.002 inch wide external contact points and connections have been produced.

5. The glass layers can be sealed by using a thermoplastic material, thus eliminating the need for a fully cross-linkable seal.

6. A uniform cavity of 0.005 inch thickness $\pm$ 10% can be obtained.

A key element of the display is the use of "commercial" flat glass rather than expensive "photomask", lapped, or otherwise specially prepared material. The display in accordance with the invention uses ordinary lime-soda glass to obtain the desired uniform cavity. The result is that a lightweight display of approximately 0.125 inch thickness is obtained.

There are three different procedures for introducing spacing materials uniformly into the LCD cell included in this invention. A first procedure is to suspend spacing beads in a fluid medium selected for inertness with respect to the spacer material, the LC substrates and with the molecular alignment layer if any. The suspension is then sprayed over the entire area of the LC substrate, preferably both substrates and the solvent allowed to dry. The LCD plates so coated are sealed by conventional methods. This process readily achieves uniform distribution of spacers and eliminates clumping. A typical mixture would be about five percent by weight of spacer material in freon or trichloroethylene. This procedure is applicable for LCD's of all sizes.

A second procedure which is best for displays under four inches is to align the LCD plates with patterns in proper registration for sealing. In non-visible corners of the plates, the plates are secured with an anerobic adhesive, such as Loc-Tite. In the unsealed condition, the plates are placed in a vacuum chamber, the chamber evacuated and the plates lowered in contact with a container of LC material in which about 0.1 to 1% of spacer beads have been added. Capillary action along with venting of the chamber causes the LCD material and spacers to move into and fill the gap between the plates. This gap is approximately twice the width of the separation between plates of the finished display. The filled, unsealed panels are removed from the chamber and put through a conventional pressure and temperature cycle to complete the seal. During this cycle, clamping pressure causes extrusion of excess LC material and reduces the cell thickness (separation) to that determined by the spacers. This procedure has an advantage over the prior procedure in that there is no question of contaminating the cell with an extraneous solvent used for carrying the spacer beads.

- 29 -

The LC material itself is a powerful surfactant and essentially eliminates the tendency for spacer particles to "stick together" or clump. As it is also highly lubricating, any stacking or clumping of spacers which remains in the cell is readily pressed out in the final sealing operation. The LC coated particles or fibers slip readily over each other until a uniform, single particle thickness spacing layer is obtained.

In a third procedure, spacer beads may be incorporated to approximately five percent by weight in the aligning polymer film, for example, polyvinyl alcohol dissolved in water. In the normal coating process, these spacers become embedded in and adhered to the aligned film layer.

Both polyamide and polyvinyl alcohol based aligning films have proved to be effective suspending agents for spacer materials, with adequate surfactant and lubricant properties that clumping or stacking problems are eliminated.

A further benefit of this invention is that the film-forming materials are dielectrics and tend to form insulating layers over the spacer particles. While the normally used spacer materials are dielectrics, commercial sources may yield residual percentages of higher conductivity particles which are difficult to remove. This invention minimizes the effect of such contaminants. Cells are then assembled as conventionally practiced. This third method is usable for LC displays which are larger than can be manufactured by the second method and also eliminates contamination by the spacer suspending fluid.

A fourth method, which provides highly uniform spacer distribution over large areas is vibrational sifting of the spacer particles through multiple, fine-mesh screens. A non-restrictive representation of this is a stack of two or three large area fine mesh screens as conventionally prepared for screen-printing, but without either emulsion or image. These screens should be larger in area than the LC substrate to be covered by about 20% at least. The screens are held in a closed, draft free chamber located above the LC substrate and are mechanically shaken with any convenient vibrating mechanism. The spacer particles are initially placed in the top screen and are progressively sifted downward in increasingly uniform distribution by the vibration and allowed a few seconds to settle upon the substrate.

This invention is readily adaptable to large scale automated manufacture as it is highly reproducible by controlling the activation time of the vibrator.

The terminal electronics consist of a conventional microprocessor system with keyboard inputs, a communication link and its interface, and a non-conventional LCD micropressor controller and driver.

The LCD microprocessor controls and buffers input information, then stores it in temporary memory. The microprocessor determines the proper address and digit characteristics based on ROM stored information. Information is then taken from the temporary memory and input to X and Y shift registers and transferred by drivers to the display pixels. The pixels are individually addressed by selecting a row and column writing the row in parallel.

In one embodiment of the invention, once activated, the pixels are latched, and no further refresh is required. Erasure of a pixel is accomplished by utilizing a specific erase signal (not a deletion of a refresh signal).

In another embodiment of the invention, an unintelligent bias voltage is applied to the entire display. After writing, the pixel returns to the unintelligent bias. This embodiment is found to produce higher write and erasure speeds.

Erasure is accomplished by utilizing an erase signal in one embodiment equal to the level of the write signal but held for a longer period. In another embodiment, the level of the erasure signal is greater than the write signal with the period comparable in duration. In all embodiments, the erasure pulse is followed by a return to reference voltage for sum period.

The LCD drive circuit has row and column sets

- 32 -

of n-stage bidirectional shift registers and individual pixel drivers, so it converts serial character pattern data from the controller to parallel data and provides data pulses for the liquid crystal display.

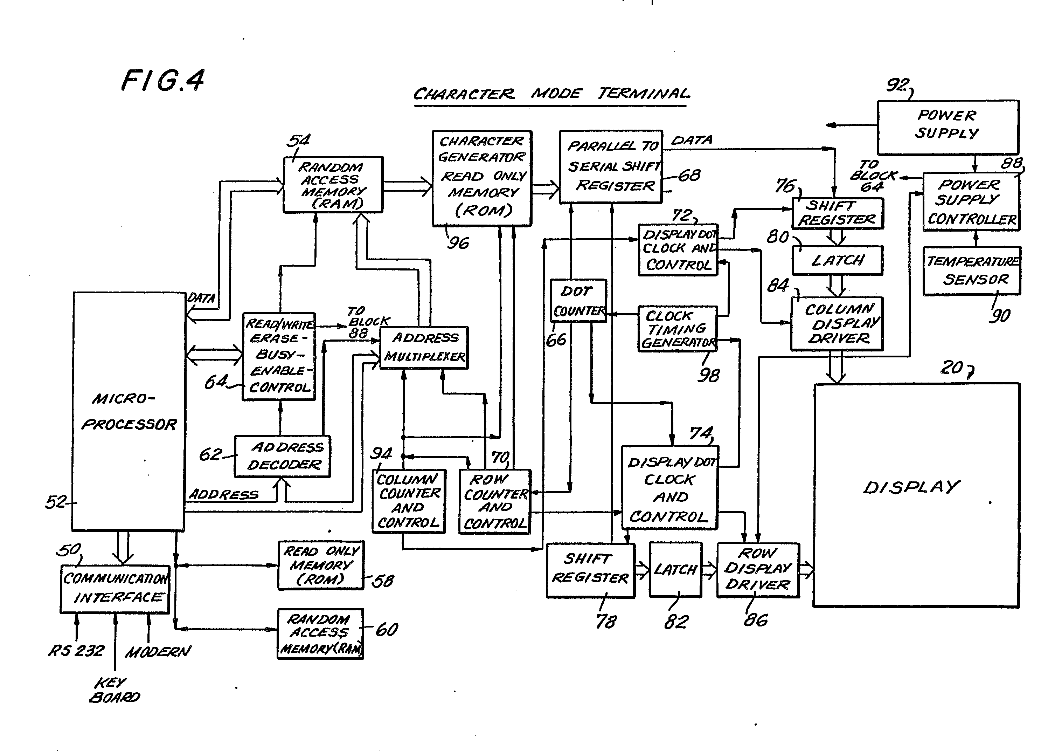

Referring now to Fig. 4, there is shown a block diagram of the electronics required to provide a display on the character mode terminal. A communication interface 50 converts external data signals into proper format for use with the microprocessor. The microprocessor 52 controls the data to be placed in memory 54 as to location by the address multiplexer 56. The microprocessor 52 is programmed by a permanent read-only memory 58 and temporary storage is provided by random access memory 60. The address decoder 62 determines sequencing of address to random access memory 54 through the address multiplexer 56 and provides an input signal to read/write erase-busy-enable-control 64 which provides a signal to the microprocessor for controlling information, such as when the read/write and other signals are to be produced. Dot counter 66 maintains control and synchronizes the proper amount of data parallel to serial shift register 68 and row counter and control 70 and the sequencing of display dot clock and control 72 and display dot clock and control 74. Display dot clock and control 72 and display dot clock and control 74 provide the control and sequencing of clock signals to shift register 76, shift register 78, latch 80 and latch 82 which latch the data to the column display driver 84 and row display driver 86. The output amplitude of column display driver 84 and row display driver 86 is controlled by power supply controller 88. Various amplitude voltages are used for different modes of operation of the display as it will be readily understood by those skilled in the art. A temperature sensor 90 varies the power supply controller 88 to compensate for temperature variation of the display. Power supply 92 provides power to the driver and provides control of the input power. Column counter control 94 and row counter control 70 determine the proper sequencing of row and column information throughout the address multiplexer. Column counter and control 94 is in synchronism with the row counter control 70 under control of the address multiplexer 56 and microprocessor 52. The character generator read only memory (ROM) 96 is preprogrammed to output dot configurations which will display the external input. The character generator read only memory 96 is also controlled by column counter and control 94 and row counter and control 70 for proper dot output. Parallel to serial shift register 68 changes a parallel signal from the character generator read only memory 96 and converts it to a serial data train.

Parallel to serial shift register 68 is controlled by clock generator 98 which is the display clock which determines and synchronizes data transferred to shift registers 76 and 78 which are the output shift registers and also controls all of the driver components.

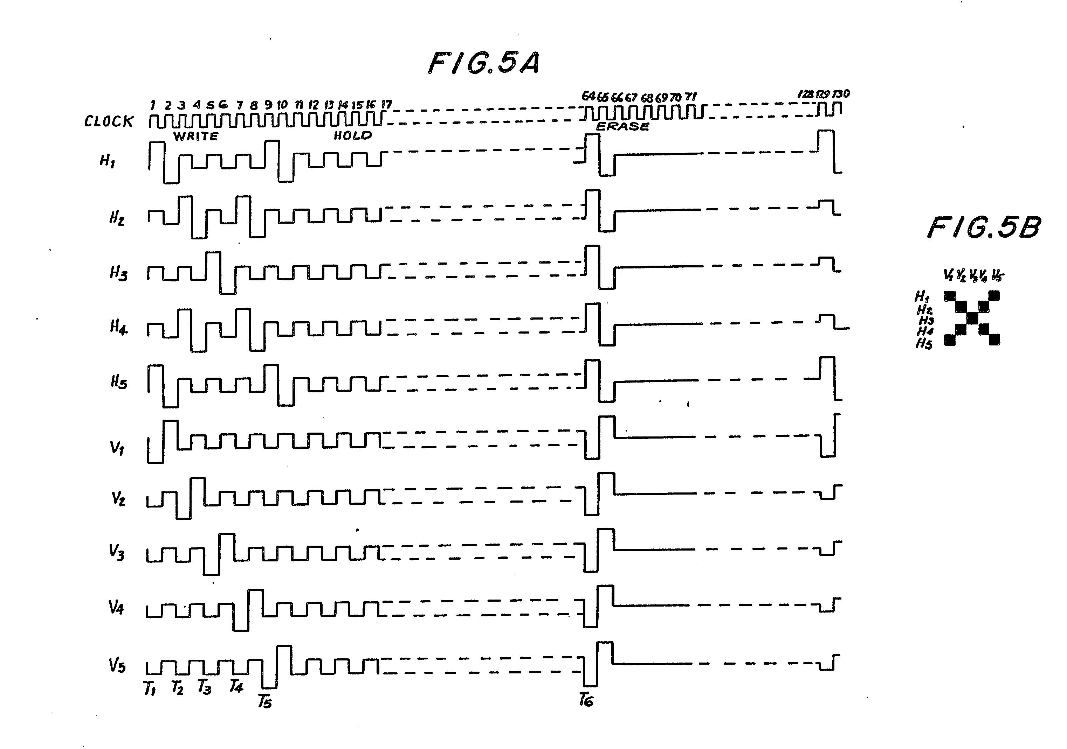

The manner in which characters are formed and displayed on the display is illustrated in Figs. 5A and 5B. In Fig. 5B, a single character space in the display represented by a five-by-five matrix array is shown. It is, of course, understood that Fig. 5B is being used for demonstrating and explanation purposes and is not to be taken as in any way limiting the invention. In Fig. 5B, the five-by-five matrix array is formed by five vertical columns, referred to as V-1 through V-5 respectively, and five horizontal rows, H-1 through H-5 respectively. Fig. 5A shows the signals which are applied to the five vertical columns, V-1 through V-5, and the five horizontal rows. H-1 through H-5 respectively, to activate the data in the five-by-five matrix character space illustrated in Fig. 5B. As illustrated, at time $t_1$, a write signal appears on lines H-1, H-5, and V-1 causing dots to appear at locations V-1, H-1 and V-1, H-5 as indicated in Fig. 5B. At time $t_2$, a write signal appears on lines H-2, H-4 and V-2, causing dots to appear at the appropriate portions of the matrix as illustrated in Fig. 5B. During the time between $T_1$ and $T_2$, non-differentiated bias signals, typically one-half the voltage of the write signals, are applied to all lines V-1 through V-5 and H-1 through H-5.

Of course, it is understood that an actual display would have many columns, typically 560, and many rows, typically 250. Figures 5A and 5B show a display in which rows are written in parallel, that is, all of the dots which, for example, appear in column V-1 for all rows of the display would be written at the same time after which all rows in the second column V-2 would be written. It will readily be appreciated that the columns could be written in parallel, that is, all of the dots which, for example, appear in row H-1 for all columns of the display would be written at the same time after which all columns in the second row would be written.

Returning to Fig. 5A, at time $T_3$, a write signal appears on lines V-3 and H-3 and the dot appears at the center of the matrix as shown in Fig. 5B. Similarly, at times $T_4$ and $T_5$, write signals appear which produce the other dots illustrated in Fig. 5B. As can be seen, the letter X is formed in the character space. In accordance with the invention, refresh signals are not required in order to maintain the display of the desired character, for example, the character X in Fig. 5B, for an extended period of time. When it is is desired to erase the information, an erase signal, which in Fig. 5A is produced at time $T_6$, is placed on each of the row and column lines and the display is erased in parallel.

Typically, the following voltages and times are used:

Hold voltage - 4 to 5.5 V

Write voltage - 11 to 28 V Erase voltage - 11 to 35 V

Clock period  -  1 to 15 msec

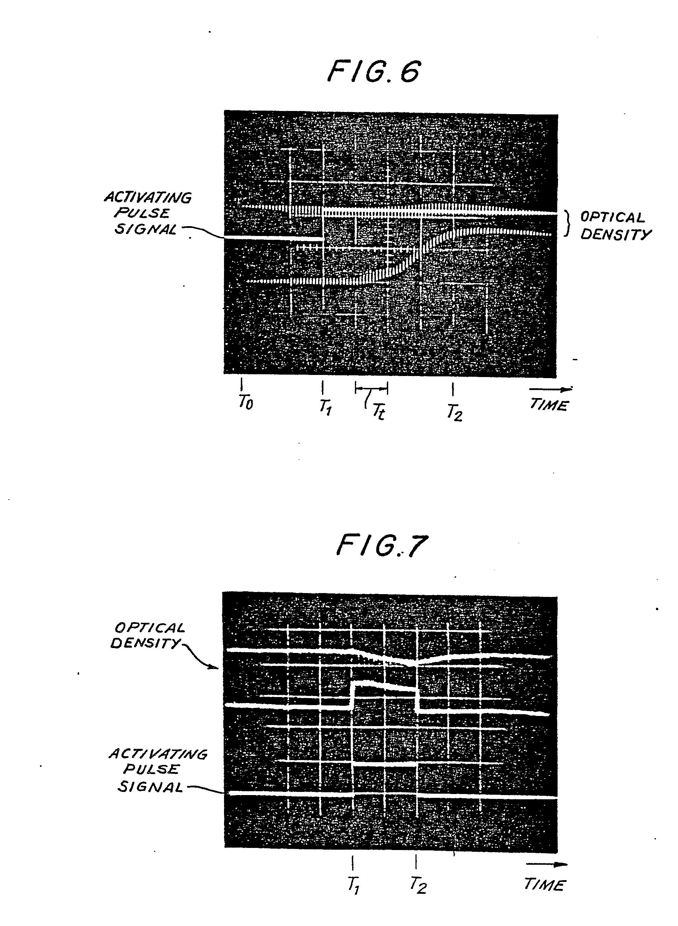

Figs. 6 and 7 illustrate the write and erase times respectively for prior displays and the display of the invention and demonstrate the increased writing and erase speed achieved when utilizing the display of the invention. Figs. 6 and 7 show the optical density of the display as a function of time and superimposed thereon the activating pulse signal. Major gradations along the time scale $T_t$ are 10 milliseconds. Referring to Fig. 6, the optical density at time $T_0$ is low, as indicated by the large amplitude of the optical density voltage, and no information is displayed at this time on the screen. At time $T_1$, a write pulse is applied to the display. As shown in Fig. 6, the optical density of the display does not change sufficiently to provide a change in the optical density of the display until time $T_2$ which is about 40 milliseconds after the write pulse. In Fig. 7, the write pulse occurs at time $T_1$ and it is seen that the optical density of the display changes almost immediately, in the order of approximately one millisecond. The erase pulse applied at time $T_2$ causes erasure of the display in also about one millisecond.

One type of liquid crystal display, made in accordance with the present invention, operates between the unwritten predominantly planar structure and the written predominantly focal conic structure of either the cholesteric or smectic phase, with a transitory predominantly aligned nematic state during write and erase. To obtain the necessary homogeneous boundary conditions, the arrangement of the liquid crystal material within the cavity. The opposing substrates upon which the row and column electrodes are patterned are coated with a polyvinyl alcohol solution and then buffed. Specifically, the display includes 480 column electrodes spaced uniformly over a 4.5 inch horizontal dimension, and 192 row electrodes spaced uniformly over a 3.5 inch vertical dimension. A nominally 10 $\mu$m thick cell is assembled and filled with a liquid crystal mixture such as E-7 with 14% by weight cholesterol nonanoate. The display is sealed and electrical connections are made to the driving circuit as described above.

Information may be written on the display in the same manner as shown in the voltage timing diagram of Figure 5A. The rows are scanned sequentially from first (H$_1$) Write pulses, which are the algebraic sum of the voltage on the columns (V$_1$ to V$_{480}$) of the scanned row, supply the text information to each row and are applied for approximately 7 milliseconds. As shown in FIG. 5A, before and after writing a non-intelligent bias voltage, which is also the sum of the row and column voltages, is applied to the entire display. A typical write voltage is 26 volts and a typical bias voltage is 8 volts. After writing the entire display, the non-intelligent bias voltage may be reduced to 4.5 volts to produce a longer persistance time than is achieved by reducing the bias voltage to zero.

Erasure of the display is accomplished by applying a net voltage of 24 volts simultaneously across all pixels for approximately 20 milliseconds and then reducing the voltage to zero. If erasure is incomplete, multiple erase voltage pulses are provided. Of course, erasure of individual pixels could be accomplished by simply applying a net voltage of 24 volts across only the individual pixels to be erased.

This display provides high contrast images under several types of viewing conditions, including transmitted light and reflective light, with or without the use of polarizers. When used with parallel polarizers and transmitted light viewing conditions, the unwritten background color is a dark blue due to the optical activity of the substantially planar state. The written pixels are a bright color due to the birefringence and scattering of the predominantly focal conic state. When this display is used with cross polarizers and transmitted light viewing conditions the unwritten background color is predominantly yellow-green due to the optical activity of the substantially planar state. The written pixels are a dark color due to the scattering and birefringence of the predominantly focal conic state. These background and image colors can be adjusted by varying the angle between the polarizers between zero and ninety degrees.

When this display is used with crossed polarizers and reflected light conditions, the background and image colors are controlled by varying the angle between the polarizers and by selection of the color of the reflector. One reflector which may be used has a mat white finish which is situated exterior to the rear surface of the glass substrate of the display. A gold dielectric layer placed beneath the indium tin oxide electrode on the inner surface of the rear substrate may also be used. When this display is used with reflective light conditions and no polarizers the colors are predominantly determined by the reflector, and contrast is obesrved due to the non-scattering (of light) properties of the predominantly planar state and the strong light scattering properties of the predominantly focal conic state.

When this display is used with light absorbing pleochroic dyes or anisotropic particles, color and intensity contrast is achieved as a result of the differences in orientation of the liquid crystal molecules in the predominantly planar and predominantly focal conic states. The orientation of the liquid crystal molecules produces corresponding orientations of the dyes or dipolar particles and thus different absorptions of light is achieved in the predominantly planar background areas and the predominantly focal conic image areas.

Another type of liquid crystal display, made in accordance with the present invention, operates between the unwritten predominantly cholesteric or smectic phase and the written predominantly aligned nematic phase. Specifically, this display operates between a predominantly focal conic structure and the predominantly aligned nematic phase. Construction of this display is similar to that described above with the exception that only small glass substances are used, typically formed with 32 row electrodes and 32 column electrodes, each spaced over an area of approximately 1.5 inches. Each row and column is individually connected to the appropriate driving output of the electronic circuit.

Information may be written on the display in the same manner as shown in the voltage timing diagram of FIG. 5A, with a net writing voltage of 34 volts and a net non-intelligent bias voltage of 11 volts. When scanning from the top or first row to the bottom or last row a row scan time of 5 milliseconds is used. With this scan time the image may show a slight flicker due to the persistance time of the aligned nematic structure of approximately several hundred milliseconds. In this scanning procedure, the display is continuously refreshed after the information is written on the last row. Flicker may be eliminated by decreasing the row scan time. A row scan time as short as sixty microseconds may be used. Erasure

- 41 -

is achieved in several milliseconds by reducing all voltages to zero.

. In this display, rear illumination with crossed polarizers produces a dark image due to the light absorption of the polarizer and the lack of scattering or birefringence of the predominantly aligned nematic structure. Background images are bright as a result of the scattering and birefringence of the predominantly focal conic structure.

When this display is used with rear illumination and no polarizers, viewing from a direction other than perpendicular to the display is required for good contrast, since the image areas are clear due to the predominantly aligned nematic structure while the background areas scatter light due to the scattering properties of the predominantly focal conic structure.

When this display is used with crossed polarizers the image areas are dark and the background areas are bright. Similarly, when no polarizers are used with reflected light viewing from a direction other than perpendicular to the display, illumination direction is required for good contrast, all in accordance with the principles described above.

Use of light absorbing pleochroic dyes or anisotropic particles can produce color and intensity contrast in this display in accordance with the principles described above.

- 42 -

While what has been illustrated and described are presently preferred embodiments of the invention, those skilled in the art will recognize that many modifications and changes can be made to the described embodiments in the invention while still coming within the scope of the invention which is more specifically defined by the following appended claims.

CLAIMS

1. A display comprising liquid crystal material contained within a defined cavity said liquid crystal material having a substantially planar structure in the absence of electrical excitation signals, said liquid crystal material arranged in a homogeneous manner within said defined cavity, means for applying predetermined electrical excitation signals to said liquid crystal material, said electrical excitation signals including a first electrical excitation signal applied in sequence to portions of the display, such that at the end of said sequence all portions of said display have received said first electrical excitation signal, second electrical excitation signals applied to selected areas of each of said portions of the display as said portion is receiving said first electrical excitation signal to cause a change in the optical characteristics of said selected areas of said portions of said display such that said liquid crystal material at said selected areas has a substantially focal conic structure, thereby producing an information display at said selected areas which information display remains on the selected areas of the display after removal of said first and second electrical excitation signals without the necessity for periodically refreshing the optical characteristics of the display and third electrical excitation signals applied to said display to selectively remove information from the display.

2. Apparatus as in Claim 1 which further includes an unintelligent bias voltage applied to all portions of the display before and after said first and second electrical excitation signals.

3. Apparatus as in Claim 1, in which said liquid crystal material includes a mixture of cholesteric - nonanoate and BDH E-7.

4. Apparatus as in Claim 1, in which said third electrical excitation signals comprise fourth electrical excitation signals applied in sequence to portions of the display, such that at the end of said sequence all portions of said display have received said fourth electrical excitation signal and fifth electrical excitation signals applied to selected areas of each of said portions of the display as said portion is receiving said fourth electrical excitation signal, to cause a change in the optical characteristics of said selected areas of said portions of said display such that said liquid crystal material at said selected areas has a substantially planar structure, thereby erasing information from the display at said selected areas.

5. A display comprising liquid crystal material contained within a defined cavity said liquid crystal material being in a predominantly cholesteric phase in the absence of electrical excitation signals, said liquid crystal material arranged in a homogeneous manner within said defined cavity, means for applying predetermined electrical excitation signals to said liquid crystal material, said electrical excitation signals including a first electrical excitation signal applied in sequence to portions of the display such that at the end of said sequence all portions of said display have received said first electrical excitation signal, second electrical excitation signals applied to selected areas of each of said portions of the display as said portion is receiving said first electrical excitation signal to cause a change in the optical characteristics of said selected areas of said portions of said display such that said liquid crystal material at said selected areas is in a substantially nematic phase, thereby producing an information display at said selected areas and third electrical excitation signals applied to said display to selectively remove information from the display.

6. Apparatus as in Claim 5 which further includes an unintelligent bias voltage applied to all portions of the display before and after said first and second electrical excitation signals.

7.   Apparatus as in Claim 5, in which said liquid crystal material is in a predominantly smectic phase in the absence of electrical excitation signals.

8.   Apparatus as in Claim 5, in which said third electrical excitation signals applied to said display to selectively remove information from the display comprise reducing the voltage across the entire display to zero.

9.   A method of bonding electrical circuit elements having circuit leads forming patterns of conductive material, so as to interconnect the patterns of conductive material of said elements, comprising the steps of:

printing conductive resin material on the patterns of conductive material of at least one of said elements;

drying said conductive resin;

aligning the patterns of conductive material of said elements; and,

fusing said elements by melting and compressing said resin to thereby interconnect the patterns of conductive material on said circuit elements.

10. A method of bonding electrical circuit elements, having circuit leads forming patterns of conductive material so as to interconnect the patterns of conductive material of said elements, comprising the steps of:

printing conductive resin material on the patterns of conductive material of at least one of said elements;

printing dielectric resin material around the patterns of conductive material of at least one of said elements;

drying said conductive and dielectric resins;

aligning the patterns of conductive material of said elements; and,

fusing said elements by melting and compressing said resins to thereby interconnect the patterns of conductive material on said circuit elements.

11. A method of bonding electrical circuit elements having circuit leads forming patterns of conductive material, so as to interconnect the patterns of conductive material of said elements, comprising the steps of:

printing dielectric resin material around the patterns of conductive material of a least one of said elements;

drying said dielectric resin;

aligning the patterns of conductive material of said elements; and,

fusing said elements by melting and compressing said resin to thereby interconnect the patterns of conductive material.


12. A method as in Claim 9, 10 or 11, in which at least one of said electrical circuit elements comprises patterns of conductive material formed on one of the substrates of a liquid crystal display.


13. A method as in Claim 9, 10 or 11, in which at least one of said electrical circuit elements comprises flexible electrical circuit elements having flexible circuit leads forming patterns of conductive material.


14. A method for spacing the substrates of a liquid crystal display from each other, comprising the steps of:

suspending spacer particles in a carrier which is inert with respect to said substrates;

spraying said suspension onto the surface of at least one of said substrates to coat said surface with said suspension; and,

sealing said substrates to each other such that said spacer particles lie between said substrates.


15. A method for spacing the substrates of a liquid crystal display from each other, comprising the steps of:

sifting spacer particles onto at least one of said substrates; and,

sealing said substrates to each other such that said spacer particles lie between said substrates.


16. A method as in Claim 15, in which said spacer particles are sifted through a plurality of screens which are disposed above at least one of said substrates and which are preferably held in a draft-free chamber and vibrated.


17. A method for creating a flexible electric circuit comprising the steps of:

cutting a pattern into a flat plate or into a roll;

filling said pattern with a conductive resin; and,

applying said plate or said roll to a flexible substrate such that said conductive material is transferred to said substrate to form a conductive pattern thereon.


18. A display comprising a material contained within a defined cavity which responds to electrical excitation signals to affect changes in the optical characteristics of the display at selected areas of said display, said material including a liquid crystal medium and dipolar particles incorporated therein to interact with the liquid crystal material, said dipolar particles being surface treated such that operation of the display is independent of any interaction between said electrical excitation signals and said dipolar particles and the interaction between said dipolar particles and said liquid crystal medium is enhanced.

19. The display of Claim 19, wherein said dipolar particles are selected from a group consisting of aluminum and gold, or from a group consisting of surface clad silver, chromium and copper.

20. The features as herein described, or their equivalents, in any novel selection.

0104003
1/4

FIG.1

FIG.2

FIG.3

# FIG.4

CHARACTER MODE TERMINAL

0104003
2/4

FIG.5B

FIG.5A

## FIG. 6

ACTIVATING
PULSE
SIGNAL

} OPTICAL
DENSITY

$T_0$      $T_1$   $T_t$    $T_2$    TIME

## FIG. 7

OPTICAL
DENSITY

ACTIVATING
PULSE
SIGNAL

$T_1$    $T_2$    TIME